Europäisches Patentamt

European Patent Office

Office européen des brevets

(19)

(11) **EP 1 152 463 A1**

(12) **EUROPEAN PATENT APPLICATION**
published in accordance with Art. 158(3) EPC

(43) Date of publication:
07.11.2001 Bulletin 2001/45

(51) Int Cl.7: **H01L 21/768**, H01L 21/314

(21) Application number: 00900172.8

(86) International application number:
**PCT/JP00/00079**

(22) Date of filing: **11.01.2000**

(87) International publication number:
**WO 00/42652 (20.07.2000 Gazette 2000/29)**

(84) Designated Contracting States:
**AT BE CH CY DE DK ES FI FR GB GR IE IT LI LU MC NL PT SE**

(30) Priority: **12.01.1999 JP 546899**

(71) Applicant: **TOKYO ELECTRON LIMITED**
**Minato-ku, Tokyo 107-8481 (JP)**

(72) Inventor: **ISHIZUKA, Shuichi**
**Nakakoma-gun, Yamanashi 409-3867 (JP)**

(74) Representative: **Liesegang, Roland, Dr.-Ing. et al**
**FORRESTER & BOEHMERT**
**Pettenkoferstrasse 20-22**
**80336 München (DE)**

(54) **SEMICONDUCTOR DEVICE AND ITS PRODUCTION METHOD**

(57)     On a first interlayer insulating film 41, a second wiring layer 34 comprising a plurality of wirings 35 with concave portions between adjacent ones of the wirings 35, is superposed. A second interlayer is insulting film 43 is superposed on the second wiring layer 34. The second interlayer insulating film 43 layer 34 is made of film producing material, such as CF film, that is unlikely to serve as filling due to its intrinsic property. Gasses that are used to produce the film producing material un-likely to be filling include $C_6F_6$ gas, for example, and ion-izing the gas into plasma allows the CF film to be formed on the wiring layer 34 while inhibiting the CF film from filling the concave portions 30. In this way, air gaps 36 are defined in shapes similar to those of the concave portions 30 between the wirings 35. The semiconductor device manufactured in such a manner can avoid reduc-ing its mechanical strength while capacities between the wirings are decreased.

F I G. I

EP 1 152 463 A1

## Description

TECHNICAL FIELD

The present invention relates to a semiconductor device in which depletion sections are defined between adjacent wirings so as to reduce capacities between the wirings, and to a method of manufacturing such a semiconductor device.

BACKGROUND ART

In order to implement enhanced integration in semiconductor devices, various approaches have been developed, including miniaturizing patterns and configuring circuit in multi-layer, and one of such approaches is a technique of configuring wirings in multi-layer. To realize a multi-layered wiring configuration, conductive layer is adapted to connect between the n-th wiring layer and the (n+1)-th wiring layer while thin film referred to as interlayer insulating film is formed in any region other than the conductive layer.

In progressively miniaturizing semiconductor devices, there has arisen a problem of signal delay that could be caused when pulse signals are transmitted to circuits, and such signal delay $\tau$ depends upon resistance value R between wirings and capacity C between the wirings. Thus, reduction in the capacity C between the wirings is required to decrease the signal delay $\tau$; however, since the capacity C is depending upon dielectric constant of the interlayer insulating film, selection of substances and materials from which the interlayer insulating film may be created with reduced dielectric constant has become an up-to-date issue of concern in the art to further accelerating operation speed of semiconductor devices.

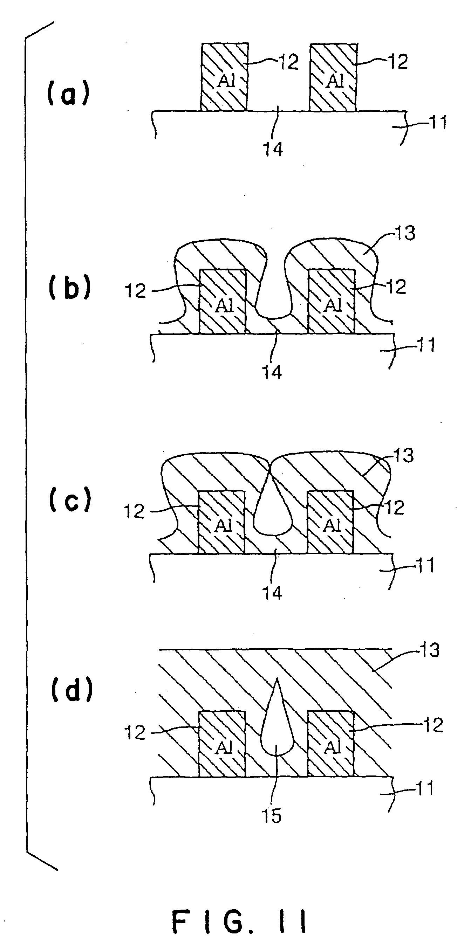

Allowing for the fact that the dielectric constant is 1 under a condition of vacuum, a new approach has been developed where depleted regions referred to as air gaps are created between wirings to reduce capacities between the wirings. For example, Japanese Patent Laid-Open Publication No. 10-150103 discloses a technique where, as shown in Fig. 11(a), wirings 12 made of materials such as aluminum (Al) is formed on a base film 11, and thereafter, gases of $SiH_4$ and $O_2$ are used for plasma CVD to create insulating film of $SiO_2$ film 13 overlaying the wirings 12.

In such a procedure of the approach, however, the $SiO_2$ film 13 is, as shown in Fig. 11(b), deposited in such a manner as is commonly called "overhang" where the $SiO_2$ film 13 fill the bottom and side-wall sections of concave portions 14 between the wirings 12 until it projects toward one another around upper peripheral corners of the concave portions 14. As the film has been accumulated in such a manner, the $SiO_2$ film 2 is deposited to bring the peripheral corners into contact with one another over the wirings 12 as shown in Fig. 11(c), and the resultant air gaps 15 between the wirings 12 are not defined as being in the similar shapes to those of the concave portions 14 along the contours of them, but with adversely reduced capacities than the concave portions 14, extending higher than the wirings 12, as shown in Fig. 11(d).

When the depleted regions due to the air gaps 15 are created higher than the wirings 12 as mentioned above, this results in the $SiO_2$ film 13 over this portion being decreased in thickness, compared with other portions, and therefore, the film over the gaps is reduced in mechanical strength so that it is liable to crack, for example. Once the film is damaged with the cracks, particles of abrasive enter the cracks to damage the devices in subsequently undergoing CMP (polishing), and/ or, when wirings are additionally to be created over the cracks, the wirings themselves may crack.

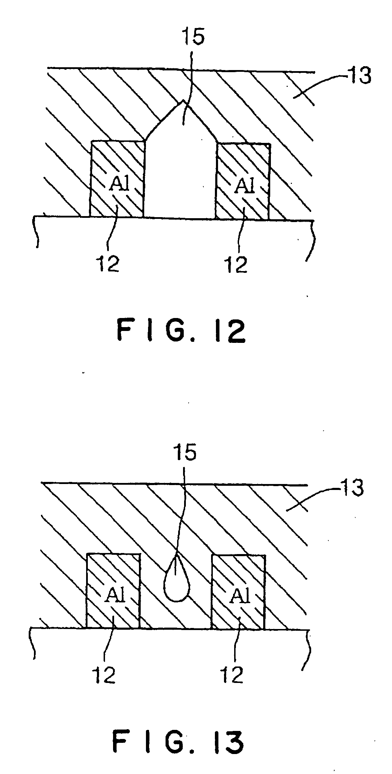

Dimensions of the air gaps 15 are controllable to some extent depending upon conditions according to which the insulating film will have been created over the wirings. For instance, a technical approach has been proposed that, with raised pressure during the film development, the insulating film can be formed without deposition on the bottom and side-wall sections of the concave portions 14 between the wirings 12; however, in such a case, similarly, the resultant air gaps 15 have part extending higher than the wirings 12, as shown in Fig. 12. Any effort that was made to avoid such undesired results has eventually brought about adversely small air gaps 15, and thus, the technological approach where the air gaps 15 are created between wirings 12 to reduce capacities between the wirings has currently not been suitable for practical use.

DISCLOSURE OF INVENTION

The present invention is directed to improve the prior art as described above, and, it is an object of the present invention to provide a semiconductor device with depleted regions being defined between wirings to reduce capacities between the wirings, wherein the depleted regions are configured into shapes similar to those of concave portions between the wirings, so as to avoid reducing their mechanical strength while the capacities between the wirings are decreased, and it is also an object of the present invention to provide a method of manufacturing such a semiconductor device.

The present invention is directed to a semiconductor device characterized by comprising a wiring layer including a plurality of wirings and concave portions defined between adjacent ones of the wirings, and an insulating film formed of film material, wherein the film producing material of the insulating film is adapted to define depleted regions within the concave portions while inhibiting itself from filling the concave portions in the wiring layer.

The present invention is directed to a method of manufacturing a semiconductor device, comprising the steps of forming a wiring layer over a substrate, which comprises a plurality of wirings and which has concave portions formed between adjacent ones of the wirings, and forming an insulating film of film producing material on the wiring layer, wherein the step of forming the insulating film includes forming the insulating film on the wiring layer while inhibiting the film material from filling the concave portions between the adjacent wirings, so as to create depleted regions within the concave portions.

BRIEF DESCRIPTION OF DRAWINGS

Fig. 1 is a sectional view showing part of an exemplary semiconductor device according to the present invention;

Fig. 2 is a diagram illustrating steps in an exemplary method of manufacturing a semiconductor device according to the present invention;

Fig. 3 is a cross-sectional view showing an exemplary apparatus using plasma in manufacturing the semiconductor device according to the present invention;

Fig. 4 is a diagram illustrating the steps in relation with features of the present invention;

Fig. 5 is a diagram illustrating steps of an exemplary process of forming a coating film when such a coating film is applied to the semiconductor device according to the present invention;

Fig. 6 is a diagram illustrating the steps in relation with features of the present invention;

Fig. 7 is a diagram illustrating steps of a method of manufacturing an alternative semiconductor device according to the present invention;

Fig. 8 is a diagram illustrating results of a test performed to observe effects of the present invention;

Fig. 9 is a diagram illustrating results of a test performed to observe effects of the present invention;

Fig. 10 is a sectional view showing part of a semiconductor device employed for explaining the diagram in Fig. 9;

Fig. 11 is a diagram illustrating an exemplary method of manufacturing a prior art semiconductor device;

Fig. 12 is a sectional view showing an example of air gaps formed in the prior art semiconductor device; and

Fig. 13 is a sectional view showing another example of the air gaps formed in the prior art semiconductor device.

BEST MODE FOR CARRYING OUT THE INVENTION

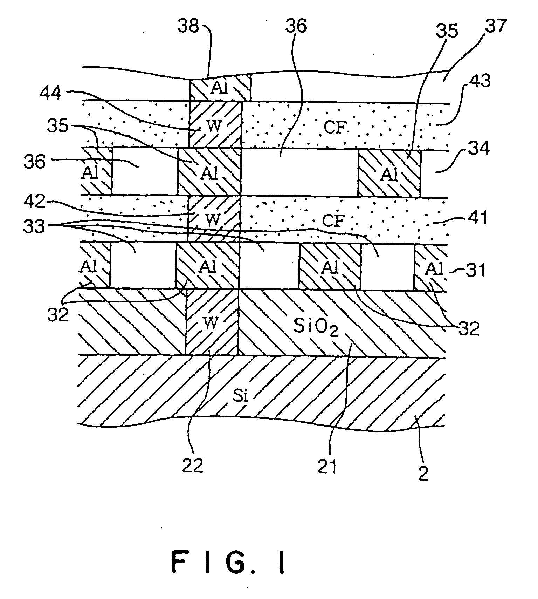

A preferred embodiment of a semiconductor device of the present invention will be described with reference to Fig. 1. Fig. 1 is a sectional view showing part of the semiconductor device that includes a silicon (Si) substrate 2, an insulating film 21 formed of material such as $SiO_2$ film, and a contact plug 22 formed in the insulating film 21 and filled with substance such as tungsten (W). A first wiring layer 31 is created on an upper surface of the insulating film 21, and the wiring layer 31 is provided with wirings 32 of aluminum (Al) and depleted regions 33 referred to as air gaps which are defined within concave portions between adjacent ones of the wirings 32.

The first wiring layer 31 as stated above, has its upper surface coated with a first interlayer insulating film 41 formed of material, such as CF film. The CF film is unlikely to serve as filling due to its intrinsic property, and the interlayer insulating film 41 is provided with plugs 42 filled with tungsten (W) to connect between the wirings 32 in the first wiring layer 31 and wirings 35 in a second wiring layer 34 which will be explained below.

The first interlayer insulating film 41 has its upper surface coated with the second wiring layer 34, and the wiring layer 34 has the wirings 35 formed of substance such as aluminum (Al) similar to the first wiring layer while having air gaps (depleted regions) 36 defined between adjacent ones of the wirings 35. The second wiring layer 34 has its upper surface superposed with a second interlayer insulating film 43 formed of material, such as CF film, that is unlikely to serve as filling due to its intrinsic property. The interlayer insulating film 43 is provided with plugs 44 filled with tungsten (W) to connect with wirings 38 in a third wiring layer 37 formed on an upper surface of the interlayer insulating film 43.

The interlayer insulating films will now be described in details. In general, interlayer insulating films include $SiO_2$ film, which is approximately 4 in its dielectric constant, and efforts have been made to obtain materials having smaller dielectric constants. Such materials include SiOF film having a dielectric constant of 3.5, and fluorinated carbon film (CF film) as mentioned above, which has a further smaller dielectric constant, may be used for such applications.

The CF film is made of material containing C and F, and a mixing rate of C to F can be optionally determined. For instance, the CF film may be made of mixture containing 65% of C and 35 % of F.

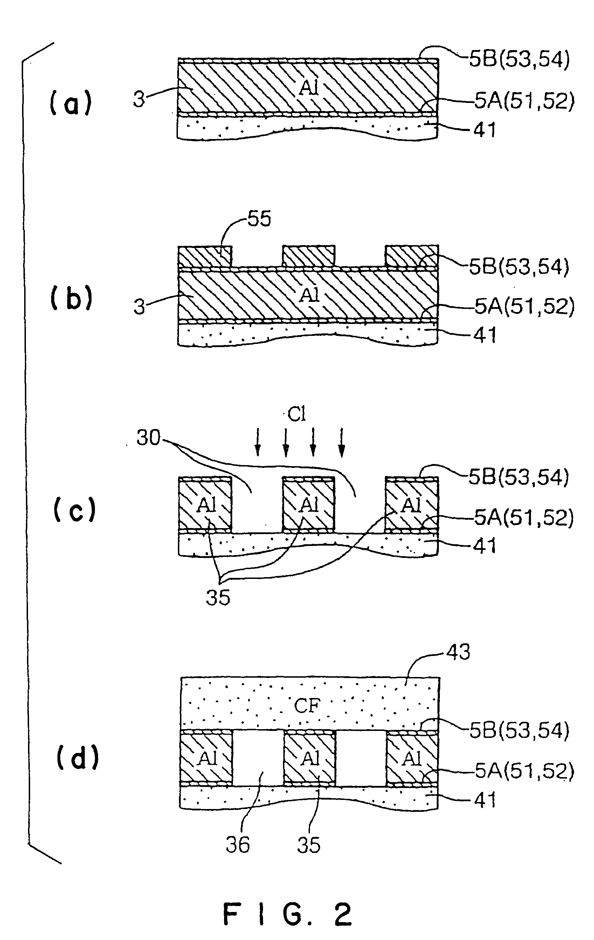

As for an exemplary method of manufacturing the semiconductor device as mentioned above, a mode will be described where the second wiring layer 34 and the second interlayer insulating film 43 are formed over the first interlayer insulating film 41, with reference to Figs. 2 to 4. First, the first wiring layer 31 is formed on the upper surface of the first interlayer insulating film 41. In this situation, as shown in Fig. 2(a), a titanium (Ti) layer 51 of 300 angstrom in thickness and a titanium nitride (TiN) layer 52 of 500 angstrom in thickness are successively formed one after another on the upper surface of the first interlayer insulating film 41. Thereafter, an aluminum (Al) layer 3 of 8000 angstrom in thickness is formed on an upper surface of the TiN layer 52. In the drawings, for the purpose of convenience, the Ti layer 51 and the TiN layer 52 together are depicted and indicated as Tin layer/Ti layer 5A.

After that, a Ti layer 53 of 300 angstrom in thickness and a TiN layer 54 of 500 angstrom in thickness are successively formed one after another on an upper surface of the Al layer 3. In the drawings, for the purpose of convenience, the Ti layer 53 and the TiN layer 54 together are depicted and indicated as TiN layer/ Ti layer 5B. The Ti layer 51 created between the first interlayer insulating film 41 and the Al layer 3 serves as sealing layer that prevents the interlayer insulating film 41 of CF film and the Al layer 3, while the TiN layer 52 serves as barrier layer that prevents pealing off between Al from diffusing from the Al layer 3 into the interlayer insulating film 41 and also prevents fluorine (F) from diffusing from the insulating film 41 into the Al layer 3.

The TiN layer 54 formed on the upper surface of the Al layer 3 serves as anti-reflection film that maintains a low reflectivity of Al when illuminating resist with light, as well as it serves as barrier film that ensures extended lifetime of Al wirings, and the Ti layer 53 develops alloy together with the Al layer 3 so as to enhance tight adhesion between the Al layer 3 and the TiN layer 54.

The Al layer 3, Ti layers 51 and 53, and, the TiN layers 52 and 54 are all produced by means of an spattering apparatus not shown; specifically, the Al layer 3 is formed by spattering targeted Al - Si with argon (Ar) gas. The Ti layers 51 and 53, and the TiN layers 52 and 54 are formed, respectively, in the same spattering apparatus using targeted Ti; specifically, the Ti layers 51 and 53 are produced by spattering the target with argon (Ar) gas while the TiN layers 52 and 54 are produced by spattering the target with both the Ar gas and nitrogen ($N_2$) gas.

Then, as shown in Figs. 2(b) to 2(c), the TiN layer 54 has its upper surface coated with resist 55 and then illuminated with light to develop predetermined patterns, and thereafter, chloride (Cl) contained gas is used to etching the Al layer in an etching apparatus not shown so that the second wiring layer 34 is formed along with the concave portions 30 between adjacent ones of the Al wirings 35.

Next, as shown in Fig. 2(d), the interlayer insulating film 43 is formed in the upper surface of the second wiring layer 34. The method of the present invention is characterized in that a wiring layer with wirings has its upper surface superposed with an interlayer insulating film made of material that is unlikely to serve as filling due to its intrinsic property, and there will be described below a case of this mode where hexafluorobenzene ($C_6F_6$) gas is used to produce CF film that is unlikely to serve as filling due to its intrinsic property.

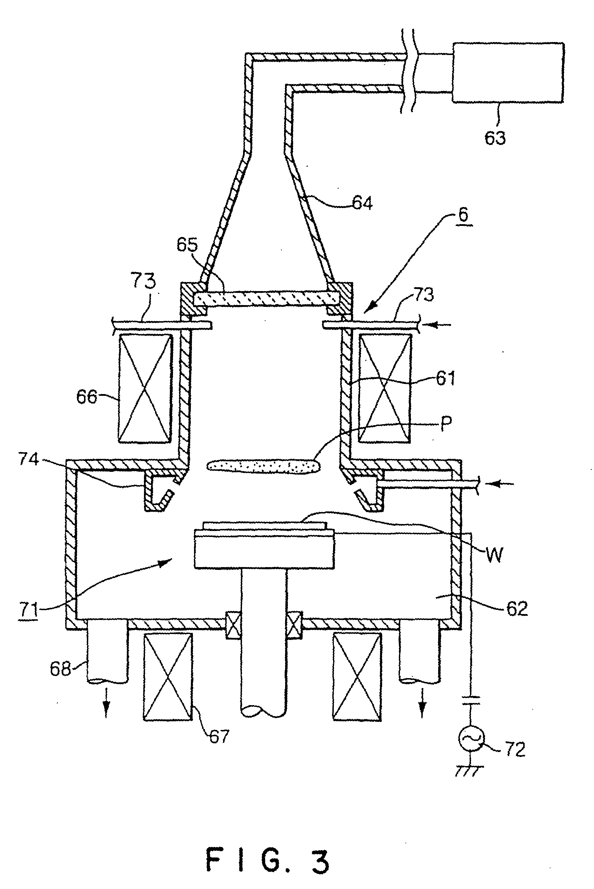

The CF film may be produced, for example, by highly ionizing gas into plasma in a plasma processing apparatus using electron cyclotron resonance (ECR), and, referring to Fig. 3, the plasma processing apparatus will now be briefly explained. In this apparatus, a vacuum reservoir 6 consisting of first and second vacuum chambers 61 and 62 is supplied with radio frequency (microwaves) of 2.45 GHz, for example, from RF power supply 63 through a waveguide 64 and a transmitting window 65 to its inside while magnetic field is developed, having a field strength of 875 gauss around ECR point P, from the first vacuum chamber toward the second vacuum chamber 62, by means of a primary electromagnetic coil 66 and a secondary electromagnetic coil 67 that are provided around the first vacuum chamber 61 and on a lower side of the second vacuum chamber 62, respectively. In this way, the magnetic field and microwaves are mutually act upon each other to produce electron cyclotron resonance at the above-mentioned ECR point P.

When the CF film is formed in this apparatus, plasma gas such as Ar gas is first introduced into the first vacuum chamber 61 via a plasma gas supply conduit 73, and then a semiconductor wafer W serving as a substrate rests on a mount 71 which is provided in the second vacuum chamber 62 and has its upper surface configured in electrostatic fastener to electrostatically fix the wafer W thereto. Next, the radio frequency power supply 63 causes microwaves to be introduced into the vacuum reservoir, while the primary and secondary electromagnetic coils 66 and 67 are activated to create magnetic field. After that, the vacuum reservoir 6 is evacuated via an exhausting pipe 68, with the film producing gas, namely, $C_6F_6$ gas being introduced into the second vacuum chamber 62 through a gas supply section 74. In this way, the $C_6F_6$ gas is ionized into plasma by means of the electron cyclotron resonance to create the CF film.

Film developing requirements at the above procedure include 90 sccm and 40 sccm of flow rates of Ar gas and $C_6F_6$ gas, respectively, 1.0 kW of microwave power, and 360 °C of substrate temperature. The procedure is carried out without applying bias power. The steps of fixing the wafer W onto the mount 71 and of the step introducing microwaves and creating the magnetic field may be performed simultaneously, but it is preferable fixing the wafer W onto the mount 71 prior to the application of plasma in order to suppress temperature rising in the wafer W caused by the plasma.

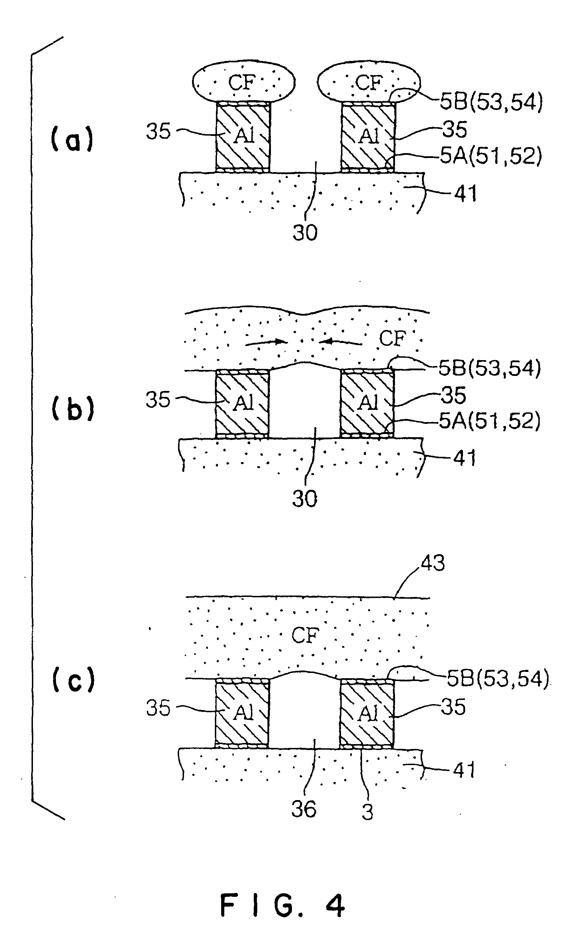

It is inferable that, as described above, using the $C_6F_6$ gas to produce the CF film results in the material being deposited to grow up to the film, maintaining a large molecular composition, because the $C_6F_6$ gas is a gas of compound having a benzene ring(s) (aromatic compound) and of large molecules and because its bonding capacity is high. Thus, as shown in Fig. 4 (a), the CF film is deposited on the upper surfaces of the Al wirings 35 and continually grow and gradually spread laterally to contact the portions deposited on the upper surfaces of the adjacent ones of the Al wirings 35 (see Fig. 4(b)) until openings of the concave portions 30 between the Al wirings 35 are eventually closed to an extent that the CF film hardly enter and fill the inside of concave portions 30.

At this point, keeping the radio frequency power supply 72 deactivated, i.e., withholding bias power can prevent plasma ions from being attracted into the wafer W during film development, thereby resulting in the CF film being more unlikely to serve as filling. Without filling the concave portions 30 in this way, the CF film 43 of 8000 angstrom in thickness is created on the upper surface of the TiN layer 54, and consequently, the air gaps (depleted regions) 36 are defined between the Al wirings 35 (see Figs. 2(d) and 4(c)). Subsequently, the second interlayer insulating film 43 is etched in predetermined patterns to form the plugs 44 configured of grooves filled with the tungsten (W) film.

The method of the present invention has made itself noteworthy in that gasses such as $C_6F_6$ gas are used to produce films that are unlikely to serve as filling due to their intrinsic properties. In this method, the wiring layer 34 is prepared in advance, with the concave portions 30 being defined between adjacent ones of the Al wirings 35, and then, the $C_6F_6$ gas is used to produce the CF film which is unlikely to be filling and which serves as an interlayer insulating film, overlying the wiring layer 34. Therefore, as stated above, the CF film is created, with the concave portions 30 kept almost completely unfilled with it. This allows the air gaps 36 to be easily created between the adjacent Al wirings 35, and moreover, allows the air gaps 36 to be defined in shapes similar to those of the concave portions 30 along the contours of them.

In other words, selecting the requirements of producing the CF film permits the CF film to be created without deposition on the bottoms or side-walls of the concave portions 30 but with deposition along the upper surface of the wirings while the film is closing the upper openings of the concave portions 30, and thus, the air gaps 36 between the wirings can be closely similar in shapes to the concave portions 30 along the contours of them.

The semiconductor device manufactured in the method according to the present invention has regions left depleted (empty) between the adjacent Al wirings. Since the regions are in vacuum state, namely, in conditions almost meeting the process requirements upon film development so as to have a dielectric constant of approximately 1, capacities between the wirings are small, which is suitable for miniaturization of the semiconductor devices. The air gap 36 defined between the wirings are in shapes almost similar to those of the concave portions 30 along the contours of them. Since the air gaps would not extend higher than the wirings, there is no risk of sections above the concave portions being reduced in mechanical strength, nor is there risk of the sections' cracking to give damage against the device.

In the foregoing mode of the embodiment, although the CF film is created under the conditions that bias power is not applied to make the shapes of the air gaps 36 that are almost similar to those of the concave portions 30 along the contours of them. However, the same results can be assuredly obtained by applying voltage lower than the normal bias power.

As has been described, as to the gasses used to produce the CF film which serves as the first and second interlayer insulating films and which is unlikely to be filling due to its property, gasses of compounds containing carbon (C) and fluorine (F) may be used, including $C_6F_5H$ (pentafluorobenzene) gas, $C_6H_5CF_3$ (parachlorotoluene) gas, $C_4F_8$ gas, $C_5F_8$ gas, $C_6F_{10}$ gas, and so forth, as well as the above-mentioned $C_6F_6$ (hexafluorobenzene) gas, and especially, compound gasses, such as $C_6F_6$ gas, $C_6F_5H$ gas, $C_6H_5CF_3$ gas, which contain C and F and have benzene rings, are preferably used.

According to the present invention, the insulating film which is formed on the wiring layer with air gaps is not limited to an example of the CF film, but any insulating film may be used if it is made of materials that are unlikely to fill the concave portions between the wirings due to their intrinsic properties. Such insulating films include SiLK film (Registered Trademark by Daw Chemical), HSQ (Hydrogen Silsesquioxane) film, MSQ (Methyl Silsesquioxane) film, and other coating films having a low fluidity and a low dielectric constant.

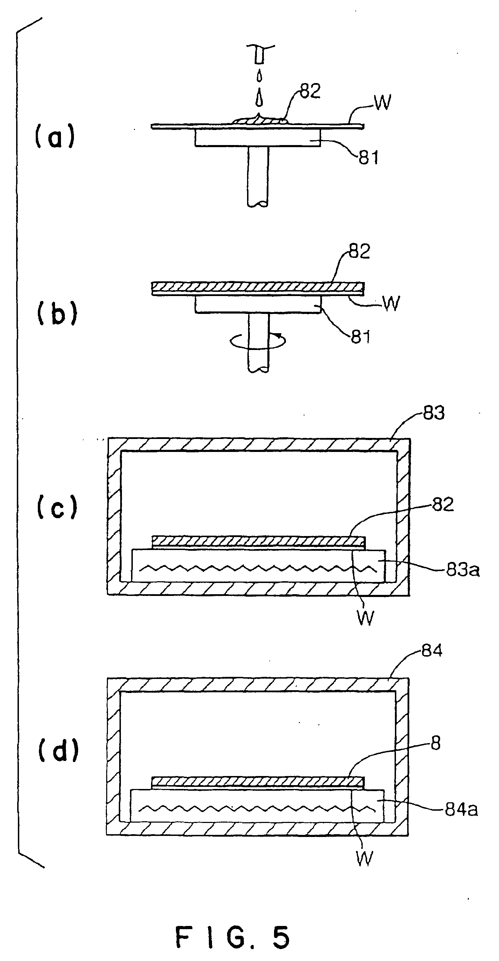

An alternative mode of the above-mentioned embodiment will now be described in the context of using the coating film, especially, of SiLK film as the first and second interlayer insulating films. As shown in Fig. 5(a), while the wafer W is retained by a retainer 81 that is rotatable in a horizontal direction, coating material 82 containing SiLK film material and solvent for the film material is supplied to the surface of the wafer W, and then the wafer W is rotated by the retainer 81 in the horizontal direction, as shown in Fig. 5(b), to diffuse the coating material 82 throughout the surface of the wafer W.

Next, the wafer W is transferred to a baking apparatus having a cabinet 83 and a heating plate 83a therein, and after resting on the heating plate 83a, the wafer W is baked, for example, at 140 °C for a predetermined period of time until the solvent is vaporized and eliminated. After that, the wafer W is transferred to a heater having a cabinet 84 and a heating plate 84a therein. After resting on the heating plate 84a, the wafer W is cured, for example, at 400 °C for a predetermined period of time until the coating 82 is polymerized and cured, and thus, SiLK film 8 is created. Also, the curing procedure may be carried out in a furnace.

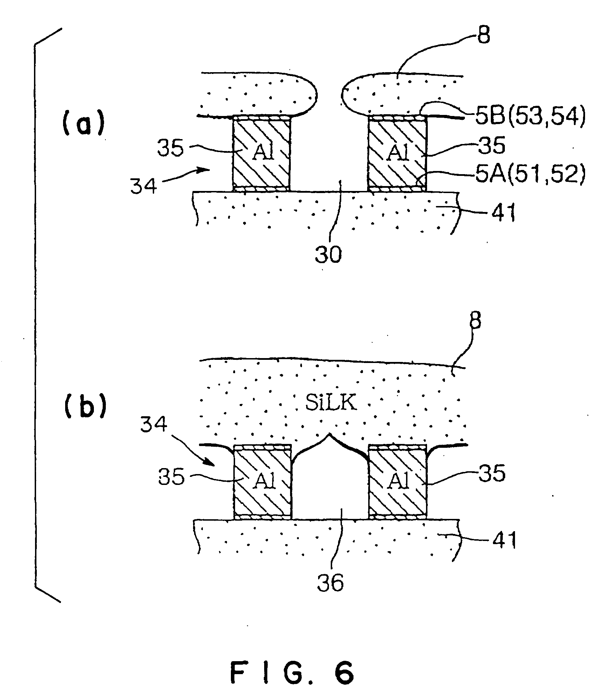

As can be seen, the SiLK film 8 is created by coating the wafer W with the coating material 82, and selecting coating requirements, such as increasing surface tension of the solvent, and/or, rotating the wafer W at higher velocity, permits the coating material 82 to diffuse in such a manner as closing openings of the concave portions 30 between the wirings 35, as shown in Fig. 6(a). As a result, the wafer W can be coated with the SILK film 8 with the concave portions 30 being hardly filled with the coating material (see Fig. 6(b)). Thus, even if the coating film is used as the second interlayer insulating film, the air gaps 36 can be easily defined into the shapes similar to those of the concave portions 30 along the contours of them.

Optimum viscosity of the coating material 82 is 15 cSt (centistokes (25°C)), and rotation rate of the wafer W is 3000 rpm.

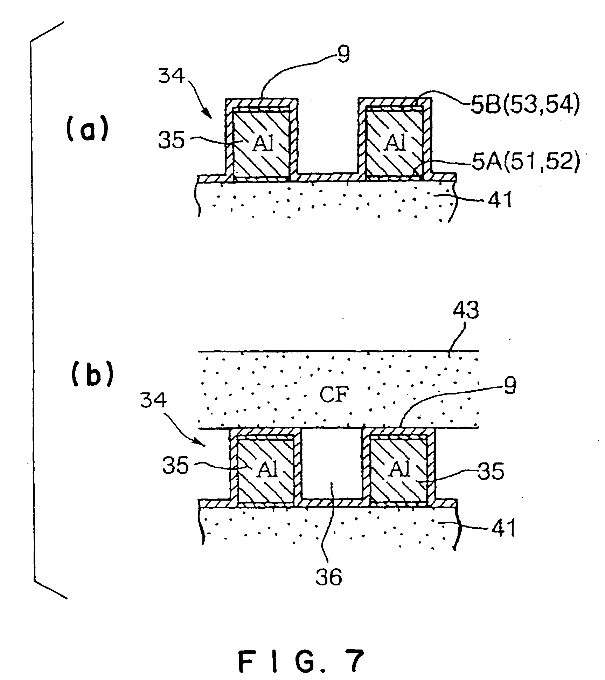

Also, in accordance with the present invention, a sealing layer may be created between the wiring layer and an interlayer insulating film formed on an upper surface of the wiring layer, as illustrated in Fig. 7. Fig. 7 shows a mode in which the CF film is created to serve as the second interlayer insulating film 43 on the upper surface of the second wiring layer 34. As shown in Fig. 7(a), a seal layer 9 having 300 angstrom in thickness and comprising SiN film, SiO2 film, or SiC film is created on an upper surface of the second wiring layer 34 with the Al wirings 35. Alphanumerics 5A and 5B in the drawings denote layers formed similar to the TiN layer/Ti layer 5A and 5B in the above-mentioned embodiment.

The sealing layer 9 is created by ionizing gasses into plasma in the plasma processing apparatus as shown in Fig. 3. As with the exemplary process requirements on SiN film, a flow rate of plasma gas such as Ar gas is 200 sccm, flow rates of film producing gasses such as $SiH_4$ gas and $N_2$ gas are 60 sccm and 100 sccm, respectively, microwave power is 2.3 kW, and bias power is 0 kW. As for the exemplary process requirements on $SiO_2$ film, the flow rate of the plasma gas such as Ar gas is 200 sccm, the flow rates of the film producing gasses such as $SiH_4$ gas and $O_2$ gas are 80 sccm and 110 sccm, respectively, the microwave power is 2.5 kW, and the bias power is 0.5 kW. Furthermore, as to the exemplary process requirements on the SiC film, the flow rate of the plasma gas such as Ar gas is 200 sccm, the flow rates of the film producing gasses such as $SiH_4$ gas and $C_2H_4$ gas are 10 sccm and 15 sccm, respectively, the microwave power is 2.4 kW, and the bias power is 0 kW.

Then, as shown in Fig. 7(b), materials that are unlikely to be filling due to their intrinsic properties are used to produce the CF film serving as the second interlayer insulating film 43, in the same way as in the above-mentioned mode, on the second wiring layer 34 superposed with the sealing layer 9. Forming the sealing layer 9 in such a way prevents the Al wirings 35 and the CF film from pealing off each other while preventing diffusion of fluorine (F) from the CF film into the Al wirings. To accomplish such effects, the sealing layer 9 may be formed over at least upper surfaces of the Al wirings superposed with the CF film.

Experiments that were performed by the inventors to observe effects of the present invention will now be described. In order to determine how dielectric property between wirings are affected by the presence and lack of the air gaps, the wiring layer, which was provided with the Al wirings of 8000 angstrom in height, 6000 angstrom in width, at intervals of 4000 angstrom between adjacent ones of the wirings, was superposed with the interlayer insulating film of 8000 angstrom in thickness, and the dielectric constant ε was measured between the wirings. The conditions of the film development are defined as follows.

[Example 1]

$C_6F_6$ gas was used to produce films, and, in the above-stated plasma processing apparatus, the plasma gasses such as Ar gas and $C_6F_6$ gas were introduced at flow rates of 90 sccm and of 40 sccm, respectively. Under the microwave power of 1.0 kW and the bias power of 0 kW, the $C_6F_6$ gas was ionized into plasma to create the CF film up to 8000 angstrom in thickness on the upper surface of the wiring layer while defining the air gaps between the wirings. Upon the procedure, in the plasma processing apparatus, the sealing layer of SiC film of 300 angstrom in thickness was created between the Al wirings and the CF film under the process conditions as has been stated.

[Example 2]

$C_6F_5CF_3$ gas was used to produce films, and, in the above-stated plasma processing apparatus, the plasma gasses such as Ar gas and $C_6F_5CF_3$ gas were introduced at flow rates of 90 sccm and of 40 sccm, respectively. Under the microwave power of 1.0 kW and the bias power of 0 kW, the $C_6F_5CF_3$ gas was ionized into plasma to create the CF film up to 8000 angstrom in thickness over the upper surface of the wiring layer while defining the air gaps between the wirings. Also, in this case, the sealing layer of SiC film of 300 angstrom in thickness was created between the Al wirings and the CF film through the process as has been stated.

[Example 3]

$C_6F_5H$ gas was used to produce films, and, in the above-stated plasma processing apparatus, the plasma gasses such as Ar gas and $C_6F_5H$ gas were introduced at flow rates of 90 sccm and of 40 sccm, respectively. Under the microwave power of 1.0 kW and the bias power of 0 kW, the $C_6F_5H$ gas was ionized into plasma to create the CF film up to 8000 angstrom in thickness over the upper surface of the wiring layer while defining the air gaps between the wirings. Also in this case, the sealing layer of SiC film of 300 angstrom in thickness was created between the Al wirings and the CF film through the process as has been stated.

[Comparison 1]

$SiH_4$ gas and $O_2$ gas were used to produce films, and, in the above-stated plasma processing apparatus, the plasma gasses such as Ar gas was introduced at a flow rate of 200 sccm while $SiH_4$ gas and $O_2$ gas were introduced at flow rates of 80 sccm and of 110 sccm, respectively. Under the microwave power of 2.3 kW and the bias power of 2.0 kW, the film producing gasses were ionized into plasma to create the $SiO_2$ film up to 8000 angstrom in thickness over the upper surface of the wiring layer while filling the concave portions between the wirings without creating the air gaps.

[Comparison 2]

$C_6F_6$ gas was used to produce films, and, in the above-stated plasma processing apparatus, the plasma gasses such as Ar gas was introduced at a flow rate of 150 sccm while the film producing gasses such as $C_6F_6$ gas and $CF_4$ gas were introduced at flow rates of 40 sccm and of 20 sccm, respectively. Under the microwave power of 1.0 kW and the bias power of 2.5 kW, the film producing gasses were ionized into plasma to create the CF film up to 8000 angstrom in thickness over the upper surface of the wiring layer while filling the concave portions between the wirings without creating the air gaps.

[Comparison 3]

$C_6F_5CF_3$ gas was used to produce films, and, in the above-stated plasma processing apparatus, the plasma gasses such as Ar gas was introduced at a flow rate of 150 sccm while the film producing gasses such as $C_6F_5CF_3$ gas and $CF_4$ gas were introduced at flow rates of 40 sccm and of 20 sccm, respectively. Under the microwave power of 1.0 kW and the bias power of 2.5 kW, the film producing gasses were ionized into plasma to create the CF film up to 8000 angstrom in thickness over the upper surface of the wiring layer while filling the concave portions between the wirings without creating the air gaps.

[Comparison 4]

$C_6F_5H$ gas was used to produce films, and, in the above-stated plasma processing apparatus, the plasma gasses such as Ar gas was introduced at a flow rate of 150 sccm while the film producing gasses such as $C_6F_5H$ gas and $CF_4$ gas were introduced at flow rates of 40 sccm and of 20 sccm, respectively. Under the microwave power of 1.0 kW and the bias power of 2.5 kW, the film producing gasses were ionized into plasma to create the CF film up to 8000 angstrom in thickness over the upper surface of the wiring layer while filling the concave portions between the wirings without creating the air gaps.

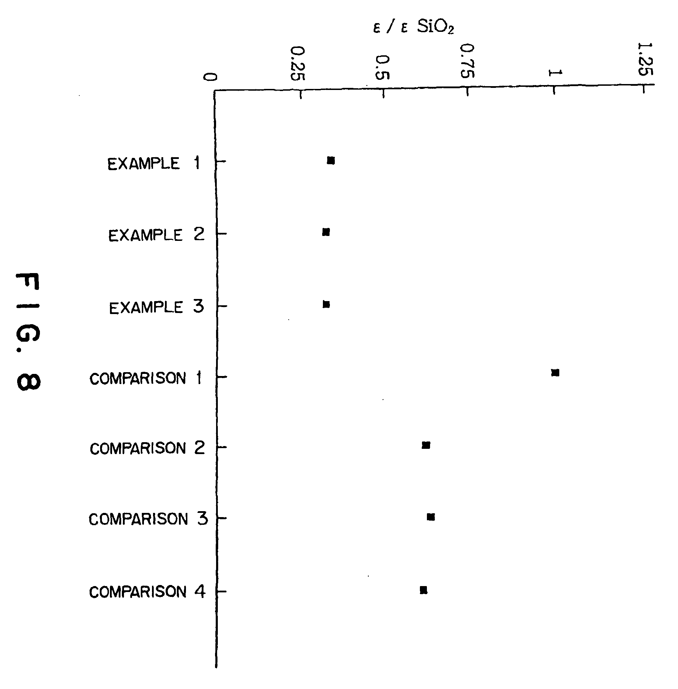

The results are shown in Fig. 8 where the dielectric constants between the wirings are designated as follows; the dielectric constant in the condition that the $SiO_2$ film is embedded between the wirings is denoted as $\varepsilon$ $SiO_2$ while a relative dielectric property between wirings in the assumption that the dielectric constant is $\varepsilon$ in each case is $\varepsilon/\varepsilon$ $SiO_2$. From the results, it was observed that, using the CF film as the interlayer insulating film as in the Embodiments 1 to 3 and the Comparisons 2 to 4, the dielectric property $\varepsilon/\varepsilon$ $SiO_2$ was lower in contrast to a case where the $SiO_2$ film was used to serve as the interlayer insulating film as in the Comparison 1, and that, defining the air gaps between the wirings as in the Embodiments 1 to 3, the dielectric property $\varepsilon/\varepsilon$ $SiO_2$ was significantly lower in contrast to a case where the interlayer insulating film was embedded between the wirings.

At the same time, it was also observed in the Embodiments 1 to 3 and the Comparisons 2 to 4 that even if the same film producing gasses were used, change in the film developing conditions allowed the CF film to alter an amount of deposition in the concave portions between the wirings so as to control the procedure to make it an option if the air gaps were to be formed or not to be.

Similarly, SiLK film, HSQ film, and MSQ film were used for carrying out the similar experiments, and it was observed that the dielectric property between wirings $\varepsilon/\varepsilon$ $SiO_2$ was approximately 0.3 in any case to form the air gaps while it was approximately 0.75 in any case to fill the gaps between the wirings with the interlayer insulating film, and it is also observed that creating the air gaps caused the dielectric property between wirings $\varepsilon/\varepsilon$ $SiO_2$ to be reduced.

Additionally, in order to determine how the change in the types and film development conditions of the interlayer insulating film could affect shapes of the air gaps, the wiring layer provided with the Al wirings of 8000 angstrom in height and 6000 angstrom in width at intervals of 4000 angstrom between the adjacent wirings was further superposed with varied types of the interlayer insulating films of 6000 angstrom in thickness under varied film developing conditions so as to observe the development of the air gaps between the wirings. The conditions of the film development are defined as follows.

[Example 4]

$C_6F_6$ gas was used to produce films, and, in the above-stated plasma processing apparatus, the plasma gasses such as Ar gas and $C_6F_6$ gas were introduced at flow rates of 90 sccm and of 40 sccm, respectively. Under the microwave power of 2.0 kW and the bias power of 0 kW, the $C_6F_6$ gas was ionized into plasma to create the CF film up to 6000 angstrom in thickness over the upper surface of the wiring layer.

[Example 5]

$C_6F_6$ gas was used to produce films, and, in the above-stated plasma processing apparatus, the plasma gasses such as Ar gas and $C_6F_6$ gas were introduced, at flow rates of 90 sccm and of 40 sccm respectively. Under the microwave power of 2.0 kW and the bias power of 1,0 kW, the $C_6F_6$ gas was ionized into plasma to create the CF film up to 6000 angstrom in thickness over the upper surface of the wiring layer.

[Example 6]

$C_6F_5CF_3$ gas was used to produce films, and, in the above-stated plasma processing apparatus, the plasma gasses such as Ar gas and $C_6F_5CF_3$ gas were introduced, at flow rates of 90 sccm and of 40 sccm. Under the microwave power of 2.0 kW and the bias power of 0 kW, the $C_6F_5CF_3$ gas was ionized into plasma to create the CF film up to 6000 angstrom in thickness over the upper surface of the wiring layer.

[Example 7]

$C_6F_5H$ gas was used to produce films, and, in the above-stated plasma processing apparatus, the plasma gasses such as Ar gas and $C_6F_5H$ gas were introduced, at flow rates of 90 sccm andof 40 sccm. Under the microwave power of 2.0 kW and the bias power of 0 kW, the $C_6F_5H$ gas was ionized into plasma to create the CF film up to 6000 angstrom in thickness over the upper surface of the wiring layer.

[Comparison 5]

$SiH_4$ gas and $O_2$ gas were used to produce films, and, in the above-stated plasma processing apparatus, the plasma gasses such as Ar gas was introduced at a flow rate of 100 sccm while $SiH_4$ gas and $O_2$ gas were introduced at flow rates of 80 sccm and of 120 seem, respectively. Under the microwave power of 2.0 kW and the bias power of 0 kW, the film producing gasses were ionized into plasma to create the $SiO_2$ film up to 6000 angstrom in thickness over the upper surface of the wiring layer.

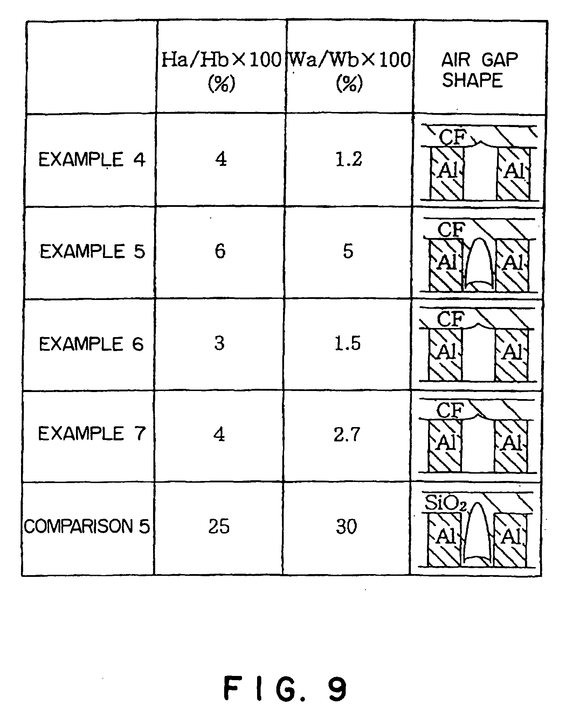

For each semiconductor device obtained in the above manners, a scanning electron microscope (SEM) was used to view the shapes of the air gaps created between the wirings, and the shapes as shown in Fig. 9 was recognized. Fig. 9 also has descriptions of calculation results of Ha/Hb and Wa/Wb with regard to the respective air gaps.

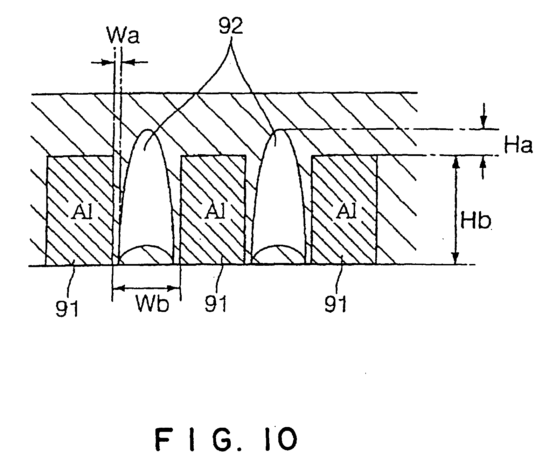

As shown in Fig. 10, Ha is a distance from upper surfaces of the wirings 91 to the highest levels of the air gaps (depleted regions) 92, Wa is the minimum distance between outer side surfaces of the wirings 91 and side surfaces of the air gaps 92, and Wb is a distance between adjacent ones of the wirings 91. In this case, Ha/Hb is smaller, a degree to which the air gaps 92 extend upward above the wirings 91 is smaller, while Wa/Wb is smaller, a volume of the interlayer insulating film on the side surfaces of the wirings 91 is smaller; in other words, the smaller the values of Ha/Hb and Wa/Wb are, the closer the air gaps 92 are in shapes to the concave portions defined in the wirings 91.

It was observed in the results described in Fig. 9 that, when the CF film was used to serve as the interlayer insulating film, the values of Ha/Hb and Wa/Wb were smaller than those obtained in the case where the $SiO_2$ was substituted, and it was appreciated that the use of the CF film was effective in avoiding deposition of interlayer insulating film over the bottoms and side walls of the concave portions between the wirings 91 while it also prevents the air gaps 92 from extending higher than the wirings 91, so that the air gaps could be created into shapes similar to those of the concave portions along the contours of them.

It was also observed in the results of Embodiments 4 and 5 that varied process conditions, might result in the shapes of the air gaps being altered even when the same film producing gasses were used, and that withholding the bias power during the film development allowed the materials filling the concave portions between the wirings 91 to be reduced in amount, so that the air gaps 92 could be defined in the shapes similar to those of the concave portions along the contours of them.

In addition to the foregoing, similar experiments were carried out, using an SILK film, an HSQ film, and an MSQ film, respectively, and the resultant values of Ha/Hb and Wa/Wb were approximately 5 and 2.2, respectively, which were smaller than the results obtained in the cases where the $SiO_2$ film was used as the interlayer insulating film. It was observed that, with those coating films, the air gaps could be defined in the shapes similar to those of the concave portions between the wirings along the contours of them.

In the semiconductor devices of the present invention as has been described hereinbefore, the wirings and plugs may be made of copper. The Ti layers and TiN layers are optionally provided between the first interlayer insulating film and the wiring layer and/or between the wiring layer and the second interlayer insulating film, and if they are unnecessary, the semiconductor devices may be configured without them.

The CF film serving as the insulating films may not only be created by developing plasma using ECR, but also by means of plasma generating apparatuses such as ICP (Inductive Coupled Plasma) in conjunction with methods where, for example, coil wound on a dome-shaped container develops and applies electric field and magnetic field to the processing gasses.

Moreover, the CF film may be created by using various apparatuses including the one in which Radio frequency of, for example, 13.56 MHz and magnetic field applied by magnetic coil mutually act upon each other to produce helicon plasma referred to as helicon wave plasma. Otherwise an apparatus in which magnetic fields are applied, in approximately parallel, to two parallel cathodes to produce plasma referred to as magnetron plasma, or another apparatus in which radio frequency power is applied between electrodes referred to as plane parallel plates and opposed to each other to produce plasma, may be used.

As has been described, according to the present invention, a semiconductor device is provided, with depleted regions being defined between wirings to reduce capacities therebetween, wherein the depleted regions can be created in shapes similar to those of concave portions between the wirings along the contours of them, so that the semiconductor device can maintain mechanical strength at the portions associated with the depleted regions while reducing capacities between wirings. Furthermore, the semiconductor device can be manufactured in a simplified procedure, with the depleted regions being defined in the shapes similar to those of the concave portions between wirings along the contours of them.

**Claims**

1. A semiconductor device, comprising:

    a wiring layer comprising a plurality of wirings so as to form concave portions being defined between adjacent ones of the wirings, and an insulating film made of film producing material, wherein the film producing material of said insulating film is adapted to define depleted regions within the concave portions while inhibiting itself from filling the concave portions in the wiring layer.

2. The semiconductor device as defined in claim 1, wherein
    the film producing material of the insulating film comprises fluorinated carbon.

3. The semiconductor device as defined in claim 1, wherein the film producing material of the insulating film comprises coating film.

4. The semiconductor device as defined in claim 1, wherein
    there is given

$$0 \leqq Ha/Hb \times 100 \leqq 6$$

    where Ha is a distance from upper surfaces of the wirings to the highest levels of the depleted regionss, and Hb is a height of the wirings.

5. The semiconductor device as defined in claim 1 or 4, wherein
    there is given

$$0 \leqq Wa/Wb \times 100 \leqq 5$$

where Wa is the minimum distance between outer side surfaces of the wirings and the depleted regions, and Wb is a width of the concave portions.

6. The semiconductor device as defined in claim 1, wherein
    TiN layer/Ti layer is interposed between the wiring layer and the insulating film.

7. The semiconductor device as defined in claim 6, wherein
    sealing layer comprising an SiN film, an $SiO_2$ film, or SiC film is interposed between the TiN layer/Ti layer and the wiring layer.

8. A method of manufacturing a semiconductor device, comprising the steps of:

    forming a wiring layer over a substrate, the wiring layer being comprising a plurality of wirings, with concave portions being defined between adjacent ones of the wirings; and
    forming an insulating film of a film producing material on the wiring layer,
    wherein, the step of forming the insulating film including forming the insulating film on the wiring layer while inhibiting the film producing material from filling the concave portions between the adjacent wirings, so as to define depleted regions within the concave portions.

9. The method as defined in claim 8, wherein
    the step of forming the insulating film on the wiring layer includes using fluorinated carbon film which is a compound of carbon and fluorine and which is unlikely to be filling due to its intrinsic property, to serve as the film producing material.

10. The method as defined in claim 9, wherein
    the step of forming the insulating film on the wiring layer includes using fluorinated carbon film which has a benzene ring and is a compound of carbon and fluorine and which is unlikely to be filling due to its intrinsic property, to serve as the film producing material.

11. The method as defined in claim 10, wherein
    the fluorinated carbon film contains hexafluorobenzene.

12. The method as defined in claim 8, wherein
    the step of forming the insulating layer on the wiring layer includes using a coating film to serve as the film producing material.

13. A method as defined in claim 12, wherein
    the step of forming the insulating layer on the wiring layer includes using a SiLK film to serve as

the coating film.

F I G. I

(a)

3

5B(53,54)
5A(51,52)
41

Al

(b)

55

3

5B(53,54)
5A(51,52)
41

Al

(c)

Cl

30

Al    Al    Al

35

5B(53,54)
5A(51,52)
41

(d)

43

CF

5B(53,54)

Al    Al    Al

5A(51,52)
41

36    35

# F I G. 2

F I G. 3

**( a )**

CF CF 5B(53,54)
35 Al Al 35
5A(51,52)
41
30

**( b )**

CF
35 Al Al 35
5B(53,54)
5A(51,52)
41
30

**( c )**

43
CF
35 Al Al 35
5B(53,54)
41
36 3

F I G. 4

F I G. 5

(a)

8

5B(53,54)

35

Al

35

34

Al

5A(51,52)

41

30

(b)

8

SiLK

34

35

Al

Al

35

41

36

F I G. 6

(a)

34
9
35
Al   Al
5B(53,54)
5A(51,52)
41

(b)

43
CF
34
9
35   Al   Al   35
41
36

# F I G. 7

FIG. 8

| | $Ha/Hb \times 100$ (%) | $Wa/Wb \times 100$ (%) | AIR GAP SHAPE |
|---|---|---|---|
| EXAMPLE 4 | 4 | 1.2 | |
| EXAMPLE 5 | 6 | 5 | |
| EXAMPLE 6 | 3 | 1.5 | |
| EXAMPLE 7 | 4 | 2.7 | |
| COMPARISON 5 | 25 | 30 | |

FIG. 9

F I G. 10

(a)

12

12

Al

Al

11

14

(b)

13

12

12

Al

Al

11

14

(c)

13

12

12

Al

Al

11

14

(d)

13

12

12

Al

Al

11

15

# F I G.  I I

F I G. 12

F I G. 13

## INTERNATIONAL SEARCH REPORT

| International application No. |
|---|
| PCT/JP00/00079 |

**A. CLASSIFICATION OF SUBJECT MATTER**
Int.Cl⁷ H01L21/768, H01L21/314

According to International Patent Classification (IPC) or to both national classification and IPC

**B. FIELDS SEARCHED**

Minimum documentation searched (classification system followed by classification symbols)
Int.Cl⁷ H01L21/768

Documentation searched other than minimum documentation to the extent that such documents are included in the fields searched
Jitsuyo Shinan Koho      1926-1996     Toroku Jitsuyo Shinan Koho   1994-2000
Kokai Jitsuyo Shinan Koho   1971-2000     Jitsuyo Shinan Toroku Koho   1996-2000

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP, 10-247648, A (Fujitsu Limited), 14 September, 1998 (14.09.98), | 1,3-5,8,12 |
| Y | Columns 25 to 60   (Family: none) | 2,6,7,10,11,13 |
| X | JP, 10-335449, A (NEC Corporation), 18 December, 1998 (18.12.98), | 1,8 |
| Y | Full text   (Family: none) | 2-7,8-13 |
| EX | JP, 11-297827, A (NEC Kyushu Ltd.), 29 October, 1999 (29.10.99), Full text   (Family: none) | 1,3,8,12 |
| EX | JP, 11-312733, A (NKK CORPORATION), 09 November, 1999 (09.11.99), Full text   (Family: none)   . | 1,4,8 |
| Y | JP, 8-148556, A (Sony Corporation), 07 June, 1996 (07.06.96), Column 58   (Family: none) | 2,9-11 |

☒ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 08 March, 2000 (08.03.00) | 21 March, 2000 (21.03.00) |

| Name and mailing address of the ISA/ | Authorized officer |
|---|---|
| Japanese Patent Office | |
| Facsimile No. | Telephone No. |

Form PCT/ISA/210 (second sheet) (July 1992)

**INTERNATIONAL SEARCH REPORT**

| International application No. |
| --- |
| PCT/JP00/00079 |

C (Continuation).  DOCUMENTS CONSIDERED TO BE RELEVANT

| Category* | Citation of document, with indication, where appropriate, of the relevant passages | Relevant to claim No. |
| --- | --- | --- |
| Y | JP, 9-172068, A (NEC Corporation),<br>30 June, 1997 (30.06.97),<br>Columns 28 to 37   (Family: none) | 5,7 |
| Y | JP, 9-237834, A (NEC Corporation),<br>09 September, 1997 (09.09.97),<br>Columns 16 to 21   (Family: none) | 6 |
| Y | JP, 9-172079, A (NEC Corporation),<br>30 June, 1997 (30.06.97),<br>Full text   (Family: none) | 6,7 |
| Y | Toshiaki Kawane, "Application of etching organic film in low-k film to Cu Damascene: conquering heat-resistance and $O_2$ plasma resistance" (in Japanese), Monthly Semiconductor World, November 1998, Vol.17, No.12, 20 October 1998 (20.10.98), Kabushiki Kaisha Press Journal, P.74-76 | 13 |
| A | JP, 9-55431, A (Nippon Steel Corporation),<br>25 February, 1997 (25.02.97),<br>Full text   (Family: none) | 1-13 |

Form PCT/ISA/210 (continuation of second sheet) (July 1992)